(19) Europäisches Patentamt
European Patent Office
Office européen des brevets

(11) **EP 0 862 275 A2**

(12) **EUROPÄISCHE PATENTANMELDUNG**

(43) Veröffentlichungstag:
02.09.1998 Patentblatt 1998/36

(51) Int. Cl.⁶: **H03M 7/40**

(21) Anmeldenummer: 98102644.6

(22) Anmeldetag: 16.02.1998

(84) Benannte Vertragsstaaten:
**AT BE CH DE DK ES FI FR GB GR IE IT LI LU MC NL PT SE**
Benannte Erstreckungsstaaten:
**AL LT LV MK RO SI**

(30) Priorität: **27.02.1997 DE 19707974**

(71) Anmelder:
**SIEMENS AKTIENGESELLSCHAFT**
**80333 München (DE)**

(72) Erfinder: **Schneider, Claus**
**81739 München (DE)**

(54) **Schaltungsanordnung zur Dekodierung variabler Längencodes**

(57) Es wird eine neue Schaltungsanordnung zur variablen Längendekodierung vorgeschlagen, die mit einer geringeren Anzahl von benötigten Datenregistern auskommt. Die Schaltungsanordnung weist einen ersten Barrel-Shifter (BS_IN) und einen zweiten Barrel-Shifter (BS_OUT) und ein VLC-Register (VLC) zur Speicherung der in dem jeweiligen Schritt zu dekodierenden Daten auf, wobei die Daten dem VLC-Register (VLC) von dem zweiten Barrel-Shifter (BS_OUT) zuführbar sind. Ferner ist eine VLD-Dekodiereinheit (LEN_LUT, SYM_LUT) vorgesehen, zur Dekodierung jeweils eines Datums der zu dekodierenden Daten. Bei der Dekodierung wird jeweils zumindest auch die Bitlänge des dekodierten Datums ermittelt. Ferner ist eine Recheneinheit (ALU) vorgesehen, der die Bitlänge des dekodierten Datums zuführbar ist. In einem Rechenregister (ACCU) wird eine von der Recheneinheit (ALU) akkumulierte Bitlänge (NEXT_ACCU) des dekodierten Datums gespeichert. Die Bitlänge des jeweils dekodierten Datums dient zur Steuerung des zweiten Barrel-Shifters (BS_OUT) und die akkumulierte Bitlänge (NEXT_ACCU) des dekodierten Datum dient zur Steuerung des ersten Barrel-Shifters (BS_IN).

EP 0 862 275 A2

**Beschreibung**

Die Dekodierung variabler Längencodes, die auch als Variable Length Dekodierung (VLD) bezeichnet wird, gewinnt besondere Bedeutung bei heutigen blockbasierten bzw. auch objektbasierten Dekodierungsverfahren zur Endropiekodierung zu kodierender Bilder.

Aus dem Dokument (Ming-Ting Sun, Design of High-Throughput Entropy Codec, VLSI Implementation for Image Communications, Elsevier Science Publishers, S. 345 - S. 365, 1993) ist es bekannt, daß die variable Längendekodierung durch folgende sequentielle Verarbeitungsschleife charakterisiert ist. Die zu dekodierenden Daten werden in einem Register gespeichert. Die Daten werden in einem zweiten Schritt durch einen Barrel-Shifter selektiert. In einem dritten Schritt wird der Code dekodiert, d.h. u.a. auch die Länge des Codes ermittelt. Hierzu wird üblicherweise eine Look Up Tabelle oder auch ein assoziativer Speicher oder ein Progamable Logic Array (PLA) oder ein Content Adressable Memory (CAM) verwendet. Der Aufbau einer solchen Look Up Tabelle ist ebenfalls aus dem Dokument (Ming-Tin Sun, Design of High-Throughput Entropy Codec, Elsevier Science Publishers, S. 345 - S. 365, 1993) bekannt. In einem weiteren Schritt wird die Länge des jeweils in dem Dekodierschritt dekodierten Symbols akkumuliert und gespeichert. Dies erfolgt in einem Akkumulator und einem Register. Tritt ein Überlauf ein, so wird ein Datenregister mit neuen Daten geladen und es werden neue zu dekodierende Daten in dem Register gespeichert. Sonst werden durch den Barrel-Shifter erneut Daten aus dem Register mit der akkumulierten Länge selektiert.

Dieses Verfahren weist durch seinen sequentiellen Charakter einen erheblichen Nachteil in der benötigten Rechenzeit zur Durchführung der variablen Längendekodierung auf. Somit wird die gesamte Bilddekodierung erheblich verzögert.

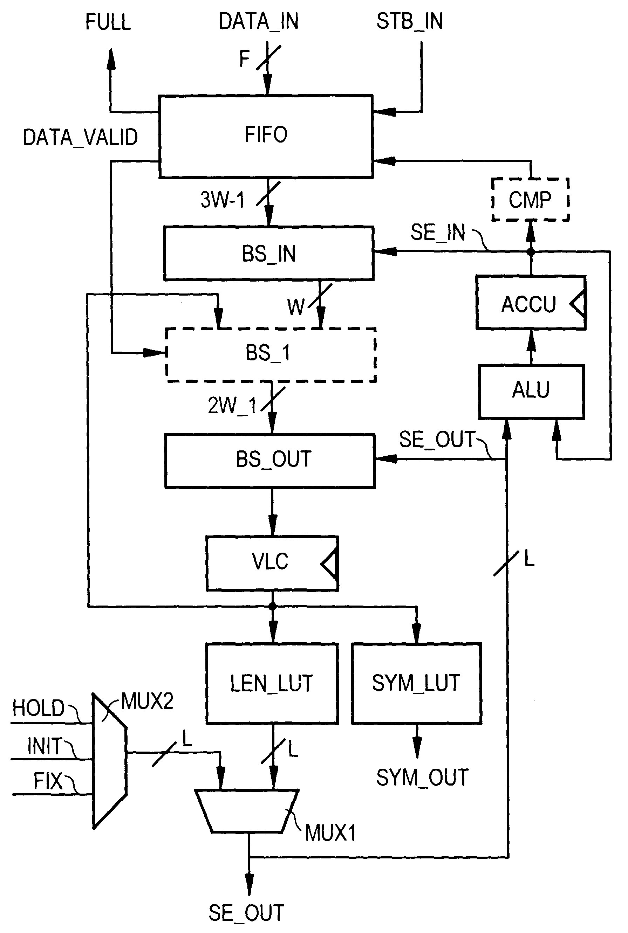

Aus (Ming-Tin Sun, Design of High-Throughput Entropy Codec, Seite 345 bis Seite 365) ist es jedoch in einer Verbesserung des zeitlichen Charakters der VLD bekannt, die oben beschriebene Verarbeitungsschleife in zwei Verarbeitungsschleifen aufzuteilen (vgl. Fig. 6 in (Ming-Tin Sun, Design of High-Throughput Entropy Codec, Seite 345 bis Seite 365)). Dadurch fällt der Akkumulator aus dem zeitkritischen Pfad: Barrel-Shifter (BS-0) - Look Up Tabelle (in (Ming-Tin Sun, Design of High-Throughput Entropy Codec, Seite 345 bis Seite 365) als PLA dargestellt) - Längenregister (L2) heraus. Es ergibt sich jedoch ein neuer ebenfalls zeitkritischer Pfad: Längenregister (L2) - Akkumulator (+) - Multiplexer - Barrel Shifter (BS1) - Datenregister (Lo, L1).

Ein Nachteil dieser Architektur ist in der relativ hohen Anzahl benötigter Datenregister zu sehen.

Somit liegt der Erfindung das Problem zugrunde, eine Schaltungsanordnung zur Dekodierung variabler Längencodes anzugeben, die mit weniger Datenregistern als bekannte Schaltungsanordnungen auskommt.

Das Problem wird durch die Schaltungsanordnung gemäß Patentanspruch 1 gelöst.

Die neu vorgeschlagene Architektur behält das Prinzip der zwei Verarbeitungsschleifen bei, besitzt aber eine neue Anordnung der Datenpfadelemente. Sie kann für beliebige Verarbeitungsbreiten eingesetzt werden.

Die Schaltungsanordnung gemäß Patentanspruch 1 weist einen FIFO-Speicher auf, in dem zu dekodierende Daten gespeichert werden. Ferner weist die Schaltungsanordnung zwei in Serie geschaltete Barrel-Shifter auf. Weiterhin ist ein VLC-Register zur Speicherung der in dem jeweiligen Schritt zu dekodierenden Daten vorgesehen, wobei die Daten dem VLC-Register von dem zweiten Barrel-Shifter zuführbar sind. Ferner ist eine VLC-Dekodiereinheit vorgesehen, die entsprechend dem vorgegebenen Inhalt der VLC-Dekodiereinheit eine Dekodierung eines Datums, das in dem VLC-Register gespeichert ist, durchführt, wobei bei der Dekodierung einer Bitlänge des dekodierten Datums ermittelt wird. Auch ist eine Recheneinheit vorgesehen, der die Bitlänge des dekodierten Datums zugeführt wird. Ferner ist ein Rechenregister vorgesehen, in dem eine von der Recheneinheit akkumulierte Bitlänge des dekodierten Datums gespeichert wird. Die Bitlänge des dekodierten Datums wird dem zweiten Barrel-Shifter zu dessen Steuerung zugeführt. Weiterhin wird die akkumulierte Bitlänge des dekodierten Datums dem ersten Barrel-Shifter zu dessen Steuerung zugeführt.

Die Schaltungsanordnung weist gegenüber der aus (Ming-Tin Sun, Design of High-Throughput Entropy Codec, Seite 345 bis Seite 365) bekannten Anordnung erheblich weniger Datenregister auf, wodurch die benötgigte Schaltungsfläche für die gesamte Schaltungsanordung reduziert wird.

Ferner ergeben sich gegenüber der Schaltungsanordnung aus (Ming-Tin Sun, Design of High-Throughput Entropy Codec, Seite 345 bis Seite 365) neue zeitkritische Pfade, so daß für einige Teilbereiche des Parameterraums (Verarbeitungs-Bitbreite) ein besseres Zeitverhalten ergibt.

Vorteilhafte Weiterbildungen der Erfindung ergeben sich aus den abhängigen Ansprüchen.

Es ist in einer Ausgestaltung der Schaltungsanordnung vorteilhaft, einen FIFO-Speicher (First-In-First-Out) zur Speicherung und Zuführung der zu dekodierenden Daten zu dem erstem Barrel-Shifter vorzusehen. Durch den Einsatz des FIFO-Speichers kann die interne Verarbeitungs-Bitbreite der Schaltungsanordnung von der Breite der Datenpfade auf Systemebene entkoppelt werden. Somit ist die Wahl der internen Verarbeitungs-Bitbreite flexibel gegenüber der externen Verarbeitungs-Bitbreite der Schaltungsanordnung.

Ferner ist es in einer Weiterbildung vorteilhaft, für den Fall, daß eine Zweierpotenz als Datenbreite für den FIFO-Speicher gewählt wird, ein dritter Barrel-Shifter vorgesehen ist, dessen Eingänge mit Ausgängen des ersten Barrel-Shifters und dessen Ausgänge mit Eingängen des zweiten Barrel-Shifters verbunden sind. In diesem Fall wird die Codelänge in der VLC-Dekodiereinheit durch die tatsächliche Codelänge minus 1 kodiert, um einen im weiteren beschriebenen Steuervektor SE_OUT möglichst klein zu halten. Dies ist deshalb möglich, da die zu dekodierenden Codes, d.h. die zu dekodierenden digitalen Daten, mindestens 1 Bit lang sind, so daß die Null als zusätzlicher Wert im binär kodierten Steuervektor SE_OUT verwendet werden kann.

In der Figur ist ein Ausführungsbeispiel der Erfindung dargestellt, das im weiteren näher erläutert wird.

Die Figur zeigt die erfindungsgemäße Schaltungsanordnung in Form eines Blockschaltbildes.

Die Schaltungsanordnung weist einen FIFO-Speicher FIFO auf, der über Eingänge des FIFO-Speichers Daten DATA_IN, die einer variablen Längendekodierung unterzogen werden sollen, zuführbar sind.

Mit F wird die Datenbreite des FIFO Speichers FIFO bezeichnet. Mit W wird die Verarbeitungs-Bitbreite der gesamten Schaltungsanordnung zur Variablen Längen Dekodierung (VLD) bezeichnet. Mit L wird der Logarithmus der Verarbeitungs-Bitbreite W zur Basis 2 bezeichnet ($L = ld (W)$).

In dem FIFO-Speicher FIFO werden die zu dekodierenden Daten DATA_IN gespeichert. Jeweils in den Pfeilen zwischen den einzelnen Elementen der Schaltungsanordnung ist durch einen Querbalken und eine Zahl, beispielsweise 2W-1, W, 3W - 1 die jeweilige Datenbreite der Verbindung zwischen den einzelnen Elementen der Schaltungsanordnung angedeutet.

Mit Ausgängen des FIFO-Speichers FIFO sind Eingänge eines ersten Barrel-Shifters BS_IN verbunden. Die Datenbreite der Verbindung beträgt 3W - 1.

Beträgt die Verarbeitungs-Bitbreite eine Zweierpotenz, so ist ein dritter Barrel-Shifter BS_1 vorgesehen, der über eine Verbindung der Datenbreite W über Eingänge des dritten Barrel-Shifters BS_1 mit Ausgängen des ersten Barrel-Shifters BS_IN verbunden ist. Der dritte Barrel-Shifter BS_1 wird von dem FIFO-Speicher FIFO über ein FIFO-Steuerungsbit DATA_VALID gesteuert. Ferner ist ein zweiter Barrel-Shifter BS_OUT vorgesehen, der über dessen Eingänge mit Ausgängen des dritten Barrel-Shifters BS_1 oder, wenn dieser nicht vorhanden ist, mit Ausgängen des ersten Barrel-Shifters BS_IN verbunden ist. Die Verbindung zwischen diesen Barrel-Shiftern weist eine Wortbreite von 2W - 1 auf.

Mit Ausgängen des zweiten Barrel-Shifters BS_OUT ist ein VLC-Register VLC verbunden. Die Verbindung zwischen dem zweiten Barrel-Shifter BS_OUT und dem VLC-Register VLC weist die Datenbreite W auf. In dem VLC-Register VLC werden die in dem jeweiligen Schritt zu dekodierenden Daten temporär gespeichert, so daß sie von einer weiteren beschriebenen Dekodiereinheit (LEN_LUT, SYM_LUT) verarbeitet werden können, d.h. für die Verarbeitungszeit in der VLC-Dekodiereinheit stabil anliegen.

Ferner ist die VLC-Dekodiereinheit (LEN_LUT, SYM_LUT) vorgesehen, die entsprechend dem vorgegebenen Inhalt der VLC-Dekodiereinheit (LEN_LUT, SYM_LUT) einer Dekodierung des Datums, das an dem VLC-Register VLC gespeichert ist, durchführt.

Weiterhin sind ein erster Multiplexer MUX1 und ein zweiter Multiplexer MUX2 vorgesehen, dessen Funktionalität im weiteren beschrieben wird.

Eine Recheneinheit ALU ist vorgesehen zur Berechnung einer im weiteren beschriebenen akkumulierten Bitlänge des dekodierten Datums. Die Recheneinheit ALU ist über den ersten Multiplexer MUX1 mit einem Ausgang der VLC-Dekodiereinheit (LEN_LUT, SYM_LUT) verbunden, über den die Bitlänge des dekodierten Datums durchführbar ist. Die Datenwortbreite dieser Verbindung beträgt L.

Mit Ausgängen der Recheneinheit ALU ist ein Rechenregister ACCU verbunden, in dem die unten beschriebene akkumulierte Bitlänge des dekodierten Datums gespeichert wird. Ausgänge des Rechenregisters sind zum einen mit einem Steuereingang SE_IN des ersten Barrel-Shifters BS_IN verbunden und zum anderen in einer Rückkopplung wiederum mit Eingängen der Recheneinheit ALU.

Ferner ist ein Komparator CMP vorgesehen, dessen Eingänge mit Ausgängen des Rechenregisters ACCU gekoppelt sind. Der Komparator CMP kann jedoch entfallen, wenn als Verarbeitungs-Bitbreite eine Bitbreite einer Zweierpotenz gewählt wird. Ferner ist die VLC-Dekodiereinheit (LEN_LUT, SYM_LUT) mit einem Steuereingang SE_OUT des zweiten Barrel-Shifters BS_OUT verbunden zur Steuerung des zweiten Barrel-Shifters BS_OUT.

Bei der Initialisierung (INIT an zweitem Multiplexer MUX2) wird der zweite Barrel-Shifter BS_OUT durch den ersten Multiplexer MUX1 und den zweiten MUX2 derart angesteuert, daß rechtsbündig die Daten von dem ersten Barrel-Shifter BS_IN übernommen werden. Durch das ebenfalls rückgesetzte Rechenregister ACCU wird der erste Barrel-Shifter BS_IN derart gesteuert, daß linksbündig das erste Datenwort des FIFO-Speichers FIFO übergeben wird.

Der FIFO-Speicher FIFO ist derart ausgestaltet, daß an seinen Ausgängen die letzten drei Stufen des zu kodierenden Datenwortes parallel zur Verfügung stehen und der erste Barrel-Shifter BS_IN mit Daten versorgt werden. Der FIFO-Speicher FIFO wird intern durch ein Strobesignal STB_OUT gesteuert, das einen Überlauf der Recheneinheit ALU anzeigt. Wird als FIFO-Datenbreite eine Zweierpotenz gewählt, so kann der Komparator CMP entfallen und als Strobesignal STB_OUT kann das Carry-Bit der Recheneinheit ALU verwendet werden. Zur externen Steuerung des FIFO-Speichers FIFO stehen ein Ladesignal STB_IN und ein Statussignal FULL zur Anzeige des gefüllten FIFO-Speichers FIFO zur Verfügung.

Der dritte Barrel-Shifter BS_1 wird nur bei Verarbeitungs-Bitbreiten, die Zweierpotenzen aufweisen, benötigt. In diesen Fällen wird die Codelänge in der VLC-Dekodiereinheit (LEN_LUT, SYM_LUT) durch die tatsächliche Codelänge minus 1 codiert, um einen Steuervektor SE_OUT möglichst klein zu halten. Dies ist deshalb möglich, da die zu dekodierenden Codes mindestens 1 Bit lang sind, so daß die Null als zusätzlicher Wert im binär codierten Steuervektor SE_OUT mit verwendet werden kann. Der dritte Barrel-Shifter BS_1 wird vom FIFO-Steuersignal DATA_VALID gesteuert und führt, falls der gesamte Ausgangsvektor des FIFO-Speichers FIFO, d.h. alle drei parallelen Ausgangsstufen gültig sind, eine Verschiebung um 1 Bit durch.

Die „untere Verarbeitungsschleife" besteht aus dem VLC-Register VLC, der VLC-Dekodiereinheit, dem ersten Multiplexer MUX1 und dem zweiten Barrel-Shifter BS_OUT. Mit dieser Verarbeitungsschleife wird die Länge des aktuell zu dekodierenden Datums und das jeweilige Datum SYM_OUT dekodiert, wobei das aktuelle Codewort immer linksbündig ebenfalls im Register VLC gespeichert ist.

Die „obere Verarbeitungsschleife" weist das Rechenregister ACCU, den ersten Barrel-Shifter BS_IN und ggf. den dritten Barrel-Shifter BS_1, den FIFO-Speicher FIFO und die Recheneinheit ALU auf. Mit dieser Verarbeitungsschleife werden neue Daten, die dekodiert werden sollen, geladen und die „untere Verarbeitungsschleife" wird mit den Daten versorgt.

Für die Verarbeitung von gemischten Codes mit variabler und fixer Länge kann über den zweiten Multiplexer MUX2 über den ersten MUX1 eine feste vorgebbare Länge FIX, die zur Dekodierung verwendet werden soll, eingekoppelt werden.

Die Recheneinheit ALU führt folgende Operation aus, wobei jeweils die akkumulierte Bitlänge des dekodierten Datums NEXT_ACCU berechnet wird, wobei in der nachfolgenden Vorschrift die Operanden in eckigen Klammern je nach Verarbeitungs-Bitbreite bzw. FIFO-Datenbreite optional sind:
NEXT_ACCU: = ACCU + SE_OUT + [DATA_VALID] - [F x STB_OUT]

Der jeweils aktuelle akkumulierte Wert der Bitlänge des dekodierten Datums NEXT_ACCU wird also berechnet aus der Summe des aktuellen Wertes des Rechenregisters ACCU, den Steuervektor SE_OUT und, falls eine Zweierpotenz als Verarbeitungs-Bitbreite gewählt wurde, dem FIFO-Steuersignal DATA_VALID mit dem Wertebereich (0,1). Davon wird, falls die Datenbreite des FIFO-Speichers FIFO eine Zweierpotenz ist, die FIFO-Datenbreite F nur dann subtrahiert, wenn das binäre Signal STB_OUT mit dem Wertebereich (0,1) aktiv, d.h. logisch 1 ist. Außerhalb der Recheneinheit ALU wird der Steuervektor SE_OUT durch den ersten Multiplexer MUX1 und den zweiten Multiplexer MUX2 auf Null gesetzt, falls das FIFO-Steuersignal DATA_VALID inaktiv, d.h. logisch Null ist. Andernfalls wird von dem ersten Multiplexer MUX1 die aktuell von der VLC-Dekodiereinheit (LEN_LUT, SYM_LUT) dekodierte Bitlänge des dekodierten Datums an den Steuervektor SE_OUT übergeben.

**Patentansprüche**

1. Schaltungsanordnung zur Dekodierung Varialbler Längen Codes,

   - mit einem ersten Barrel-Shifter (BS_IN), in dem die zu decodierenden Daten ausgewählt werden,
   - mit einem zweiten Barrel-Shifter (BS_OUT), dessen Eingänge mit Ausgängen des ersten Barrel-Shifters (BS_IN) verbunden sind,
   - mit einem VLC-Register (VLC) zur Speicherung der in dem jeweiligen Schritt zu dekodierenden Daten, wobei die Daten dem VLC-Register von dem zweiten Barrel-Shifter (BS_OUT) zugeführt werden,
   - mit einer VLC-Dekodiereinheit (LEN_LUT, SYM_LUT), die entsprechend dem vorgegebenen Inhalt der VLC-Dekodiereinheit (LEN_LUT, SYM_LUT) eine Dekodierung eines Datums, das in dem VLC-Register (VLC) gespeichert ist, durchführt, wobei bei der Dekodierung eine Bitlänge des dekodierten Datums ermittelt wird,
   - mit einer Recheneinheit (ALU), der die Bitlänge des dekodierten Datums zugeführt wird,
   - mit einem Rechenregister (ACCU), in dem eine von der Recheneinheit (ALU) akkumulierte Bitlänge des dekodierten Datums gespeichert wird,
   - bei der die Bitlänge des dekodierten Datums dem zweiten Barrel-Shifter (BS_OUT) zu dessen Steuerung zugeführt wird, und
   - bei der die gespeicherte akkumulierte Bitlänge des dekodierten Datums dem ersten Barrel-Shifter (BS_IN) zu dessen Steuerung zugeführt wird.

2. Schaltungsanordnung nach Anspruch 1,

   - mit einem FIFO-Speicher (FIFO) zur Speicherung und Zuführung der zu dekodierenden Daten zu dem ersten Barrel-Shifter (BS_IN),
   - bei der die akkumulierte Bitlänge des dekodierten Datums dem FIFO-Speicher (FIFO) zu dessen Steuerung zugeführt wird.

3. Schaltungsanordnung nach Anspruch 2, mit einem Komparator (CMP), dessen Eingang mit einem Ausgang des Rechenregisters (ACCU) verbunden ist und dessen Ausgang mit dem FIFO-Speicher (FIFO) verbunden ist.

4. Schaltungsanordnung nach einem der Ansprüche 1 bis 3, mit einem dritten Barrel-Shifter (BS_1), dessen Eingänge mit Ausgängen des ersten Barrel-Shifters (BS_IN) und dessen Ausgänge mit Eingägngen des zweiten Barrel-Shifters (BS_OUT) verbunden sind.